# FASCICULE DE BREVET EUROPEEN

(11) **EP 0 872 848 B1**
(45) Date de publication et mention de la délivrance du brevet: **20.06.2001**
(21) Numéro de dépôt: 98460008.0
(22) Date de dépôt: 09.04.1998
(51) Int. Cl.: G11C 16/06, G11C 7/00

(54) **Circuit de lecture de mémoire avec dispositif de précharge à commande dynamique.**
Speicherleseschaltung mit Vorladungsanordnung mit dynamischer Steuerung
Memory read circuit with dynamically controlled precharge arrangement

(30) Priorité: 16.04.1997 FR 9704927
(43) Date de publication de la demande: 21.10.1998
(73) Titulaire: STMicroelectronics S.A., 94250 Gentilly (FR)
(72) Inventeur: Yero, Emilio Miguel, c/o Cabinet Ballot-Schmit, 56100 Lorient (FR)
(74) Mandataire: Ballot, Paul

(56) Documents cités:
- EP-A- 0 175 101
- EP-A- 0 643 393
- US-A- 4 725 984
- US-A- 5 083 047
- US-A- 5 353 249

## Description

La présente invention concerne un circuit de lecture de mémoire avec dispositif de précharge à commande dynamique. Elle trouve son application dans le domaine des mémoires non volatiles (EEPROM, flash EPROM).

Les mémoires sont organisées en réseaux de cellules, les cellules d'une même colonne étant reliées à une ligne de bit et les cellules d'une même rangée étant reliées à une ligne de mot. La ligne de bit permet de transmettre une information sur l'état d'une cellule mémoire située au croisement de cette ligne de bit et d'une ligne de mot sélectionnée. Cette information est ensuite traitée par un circuit de lecture pour déterminer l'état de la cellule mémoire.

Dans une mémoire EEPROM, les cellules peuvent être dans un état vierge, dans lequel elles laissent passer un courant électrique de référence, dans un état effacé, dans lequel elles laissent passer un courant supérieur au courant de référence, ou dans état programmé, dans lequel elles s'opposent au passage d'un courant. Pour lire l'information, on cherche à détecter la présence d'un courant circulant dans la ligne de bit reliée à une cellule à lire : un tel courant est présent si la cellule est effacée ou vierge, sinon elle est programmée.

Pour détecter la présence du courant, on utilise une ligne de référence semblable à la ligne de bit; cette ligne de référence est parcourue par le courant de référence pendant une phase de lecture. Ce courant de référence peut par exemple être fourni par une cellule de référence. La phase de lecture d'une cellule mémoire est précédée d'une phase de précharge de la ligne de bit et de la ligne de référence. Pendant cette phase, la ligne de bit et la ligne de référence sont préchargées à un potentiel de l'ordre de 1 volt. On limite ce potentiel à 1 volt afin d'éviter tout stress des cellules raccordées à la ligne de bit. Pendant la phase de lecture, le courant circulant dans la ligne de bit est comparé au courant de référence pour déterminer si la cellule lue est programmée ou effacée.

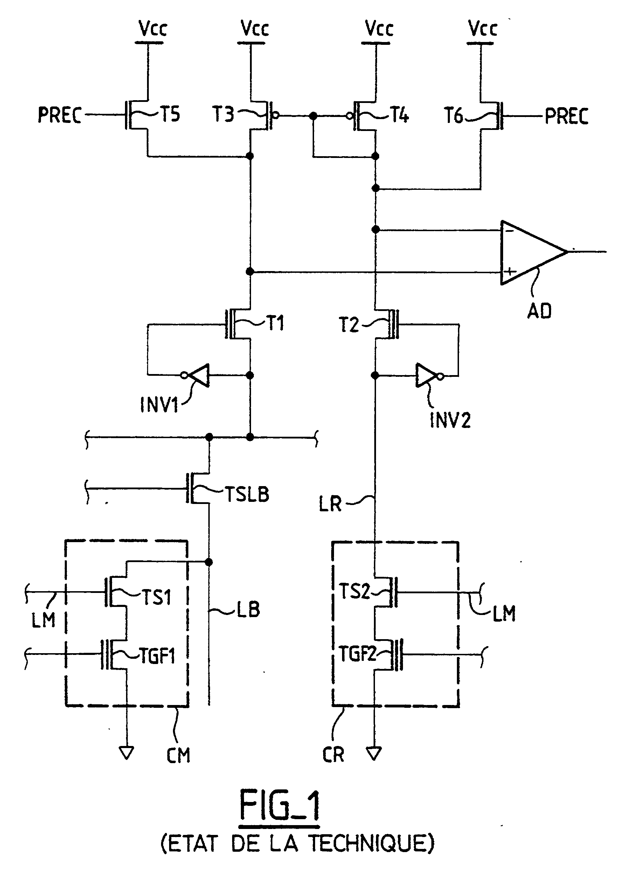

La figure 1 représente de manière simplifiée un circuit de lecture de l'art connu. Un tel circuit est aussi connu de US 4 725 984.

Une cellule mémoire CM, située au croisement d'une ligne de mot LM et d'une ligne de bit LB est sélectionnée par la ligne de mot et délivre une information sur la ligne de bit. De manière classique, la cellule mémoire CM est constituée d'un transistor à grille flottante TGF1 monté en série avec un transistor de sélection TS1. La grille de commande du transistor de sélection TS1 est reliée à la ligne de mot LM alors que la grille de commande du transistor TGF1 reçoit une tension de lecture pendant la phase de lecture. La ligne de bit LB est sélectionnée par un transistor de sélection de ligne de bit TSLB. La ligne de bit LB est préchargée en tension, pendant une phase de précharge, par un transistor de limitation de précharge T1 qui a pour fonction de fournir un courant de précharge à la ligne de bit tout en limitant le potentiel de précharge à une valeur déterminée, de 1 volt environ.

Une ligne de référence LR dont les caractéristiques sont très similaires à celles de la ligne de bit LB, notamment du point de vue des capacités parasites, est également préchargée à un potentiel d'environ 1 volt par un transistor de limitation de précharge T2. Dans l'exemple de la figure 1, la ligne de référence LR est reliée à une cellule de référence CR constituée d'un transistor de sélection TS2 monté en série avec un transistor à grille flottante TGF2. Pendant la phase de lecture, une tension de lecture est appliquée sur la grille de commande du transistor TGF2 et la ligne de référence est alors parcourue par un courant de référence.

Pour limiter la précharge de la ligne de bit LB et de la ligne de référence LR à 1 volt, les transistors T1 et T2 sont rebouclés sur eux-mêmes par des portes inverseuses INV1 et INV2. Ainsi, la source et la grille de commande du transistor T1 sont respectivement connectées à l'entrée et à la sortie de la porte inverseuse INV1. De même, la source et la grille de commande du transistor T2 sont respectivement connectées à l'entrée et à la sortie de la porte inverseuse INV2. Ces quatre éléments forment alors un dispositif de limitation de précharge des lignes LB et LR. Pour obtenir le potentiel de précharge recherché, on détermine la taille des transistors de la porte inverseuse en fonction de la capacité équivalente de la ligne de bit et de la ligne de référence.

Pour lire l'état des cellules, on effectue une comparaison entre le courant consommé par la ligne de bit et le courant de référence. Plus précisément, on compare le courant consommé par la ligne de bit à un courant qui est une fraction du courant consommé par la cellule de référence.

Pour ce faire, les drains des transistors T1 et T2 sont alimentés par les deux branches d'un miroir de courant ayant un rapport de recopie k inférieur à 1. La première branche du miroir comprend un transistor de recopie T3 et la deuxième branche comprend un transistor de référence T4. Le transistor de recopie T3 tend à recopier le courant circulant dans le transistor de référence T4. Classiquement le rapport de recopie est égal à 1/2.

Le transistor de recopie T3 est un transistor de type P ayant sa source reliée à une borne d'alimentation Vcc et son drain est relié au drain d'un transistor T1. Le transistor de référence T4 est de là même façon un transistor de type P dont la source connectée à la borne d'alimentation Vcc et dont le drain est relié au drain du transistor T2.

Les grilles de commande des transistors T3 et T4 sont reliées entre elles et la grille du transistor T4 est reliée à son drain.

Un amplificateur différentiel AD a ses entrées reliées aux drains des transistors T3 et T4 et mesure l'écart entre les potentiels sur ces deux drains. Cet écart est nul si les courants circulant dans les transistors T3 et T4 ont un rapport égal à k. La sortie de l'amplificateur AD fournit un signal indiquant si le rapport des courants est supérieur ou inférieur à k.

Pour accélérer la précharge de la ligne de bit et de la ligne de référence, le circuit de lecture est complété par deux transistors de précharge T5 et T6. Ces transistors sont commandés par un signal de précharge PREC actif pendant la phase de précharge et ils permettent d'appliquer une tension proche de la tension d'alimentation sur les drains des transistors de précharge T1 et T2 pendant la phase de précharge. Ces transistors sont généralement très peu résistifs pour ne pas pénaliser le temps de précharge de la ligne de bit ou de la ligne de référence.

L'impulsion du signal de précharge PREC appliqué sur les grilles des transistors T5 et T6 est de durée fixe. Cette durée tient compte de plusieurs paramètres. En effet, le temps de précharge d'une ligne de bit peut varier en fonction de la température ou de la capacité variable des cellules auxquelles elle est rattachée. La durée de l'impulsion est donc choisie de façon à garantir une précharge complète quelle que soit la valeur de ces paramètres.

L'option de précharge choisie dans ce type de circuit de lecture est de précharger la ligne de bit pendant une durée prédéterminée et de limiter la tension de précharge à une valeur limite dès que la tension de précharge tendrait à dépasser cette limite.

Le principal inconvénient de ce type de circuit de lecture est que le dispositif de limitation de la tension de précharge ne fonctionne pas de manière satisfaisante lorsque le circuit de lecture est alimentée par une faible tension d'alimentation, de l'ordre de 1,8 volts.

La solution adoptée dans la présente demande consiste à supprimer le dispositif de limitation de la précharge et à interrompre la phase de précharge lorsque la valeur limite de la tension de précharge est atteinte.

Aussi, l'invention a pour objet un circuit de lecture pour mémoire non volatile du type comportant une matrice de cellules mémoire, le circuit de lecture étant relié d'une part auxdites cellules mémoires par l'intermédiaire d'au moins une ligne de bit et d'autre part à une cellule de référence par l'intermédiaire d'une ligne de référence, lequel circuit de lecture comprend des moyens de précharge de la ligne de bit et de la ligne de référence,
caractérisé en ce que les moyens de précharge comportent des moyens pour interrompre la précharge de la ligne de bit et de la ligne de référence lorsque le potentiel de ces dernières atteint une valeur limite référencée par rapport à la masse.

Selon un mode de réalisation de l'invention, les moyens de précharge comportent:
- un circuit de comparaison du potentiel de précharge des lignes de bit et de référence avec ladite valeur limite, lequel circuit de comparaison délivre un signal de comparaison,
- des transistors de précharge pour précharger les lignes de bit et de référence, et
- des moyens de commande des transistors de précharge, lesquels moyens de commande reçoivent ledit signal de comparaison et un signal de précharge de période constante et fournissent un signal de commande aux transistors de précharge.

Selon un mode de réalisation particulier, le circuit de comparaison comporte :
- un premier transistor de type N dont le drain est connecté à une borne d'alimentation du circuit de lecture, dont la grille est connectée à la ligne de bit et dont la source est connectée à une source de courant, et
- un second transistor de type N dont la grille est connectée à la source du premier transistor, dont la source est connectée à la masse et dont le drain délivre ledit signal de comparaison.

Par ailleurs, selon une forme particulière de réalisation, les moyens de commande comportent:
- une porte de type NON ET dont une première entrée est reliée au drain du second transistor et dont une seconde entrée reçoit ledit signal de précharge de période constante,
- un troisième transistor de type P dont la grille et le drain sont respectivement connectés à la sortie et à la première entrée de la porte NON ET, et dont la source est connectée à la borne d'alimentation du circuit,
- un quatrième transistor de type P dont le drain et la grille sont respectivement connectés aux première et seconde entrées de la porte NON ET, et dont la source est connectée à la borne d'alimentation du circuit; et
- une porte inverseuse dont l'entrée est reliée à la sortie de la porte NON ET et dont la sortie est connectée à la grille des transistors de précharge.

D'autres caractéristiques et avantages de l'invention apparaîtront à la lecture de la description détaillée qui suit et qui est faite en référence aux dessins annexés dans lesquels :
- la figure 1, déjà décrite, représente un circuit de lecture de l'art antérieur;
- la figure 2 représente un circuit de lecture selon un premier mode de réalisation de l'invention, et
- la figure 3 est une variante du circuit de lecture de la figure 2.

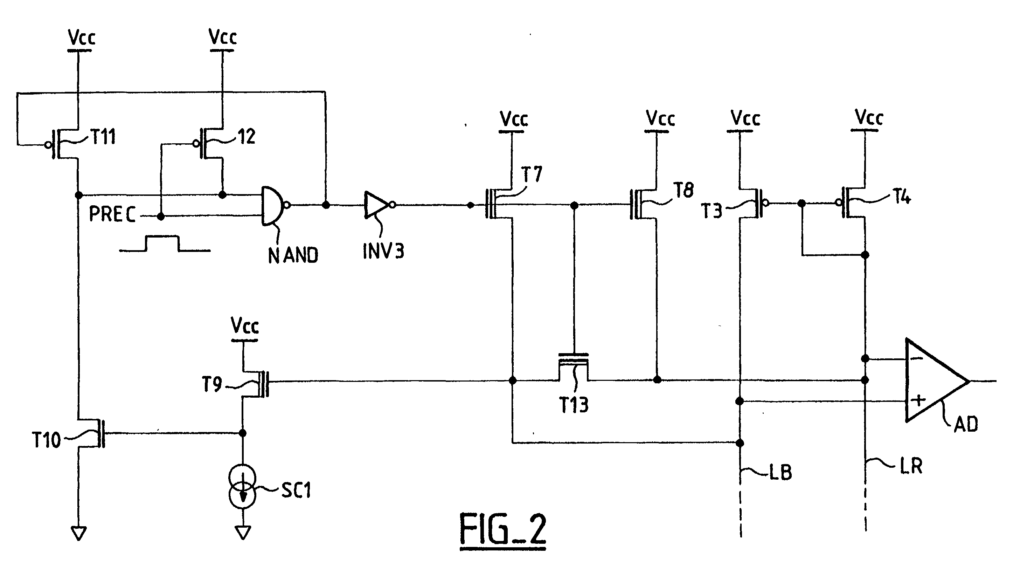

La figure 2 représente un premier mode de réalisation d'un circuit de lecture selon l'invention.

Selon l'invention, pendant l'étape de précharge, on compare le potentiel de précharge des lignes de bit et de référence à une valeur, limite. Dès que le potentiel de précharge dépasse cette valeur, l'étape de précharge est stoppée. Ainsi, on ne précharge la ligne de bit LB et la ligne de référence LR que le temps nécessaire.

D'après la figure 2, les moyens de précharge comportent:
- un circuit de comparaison du potentiel des lignes de bit et de référence avec une valeur limite, lesquel circuit de comparaison délivre un signal de comparaison,
- des transistors de précharge pour précharger la ligne de bit et la ligne de référence, et
- des moyens de commande des transistors de précharge, lesquels moyens de commande reçoivent le signal de comparaison et un signal de précharge, et fournissent un signal de commande aux transistors de précharge.

Les moyens de comparaison sont constitués de deux transistors T9 et T10 de type N et d'une source de courant SC1. Le drain du transistor T9 est connecté à la borne d'alimentation Vcc du circuit de lecture et sa source est connectée d'une part à la source de courant SC1 et d'autre part à la grille du transistor T10. La source SC1 est prévue pour polariser correctement le transistor T9. On applique par ailleurs le potentiel de la ligne de bit LB sur la grille du transistor T9. Enfin, la source du transistor T10 est reliée à la masse. Ainsi, lorsque le potentiel de la ligne de bit LB est supérieure à la somme des tensions de seuil des transistors T9 et T10, le transistor T10 devient passant et le potentiel présent sur le drain de ce transistor devient à peu près égal à celui de la masse. La taille des transistors T9 et T10 est choisie de manière à ce que la somme de leurs tensions de seuil soit égale à 1 volt, valeur correspondant à la valeur limite de précharge souhaitée. Pour l'obtenir, on a donc choisi un transistor T9 qui est natif.

L'information délivrée par le circuit de comparaison est ensuite traitée par les moyens de commande. Dans l'exemple de la figure 2, les moyens de commande comportent deux transistors T11 et T12 dont les drains sont connectés à la borne d'alimentation Vcc et les sources à la première entrée d'une porte NAND de type NON ET. La première entrée de la porte NAND reçoit également l'information en provenance du circuit de comparaison et la seconde entrée de la porte NAND reçoit le signal de précharge PREC. Ce signal est également appliqué sur la grille du transistor T12. Le signal de sortie de la porte NAND est appliqué sur la grille du transistor T11. Il est d'autre part inversé par l'intermédiaire d'une porte inverseuse INV3 et appliqué sur la grille de deux transistors T7 et T8 qui sont destinés à précharger la ligne de bit LB et la ligne de référence LR.

Les moyens de précharge fonctionnent de la manière suivante: en dehors de la phase de précharge, le signal PREC présente un niveau bas; la sortie de la porte NAND présente un niveau haut et les transistors de précharge T7 et T8 sont alors bloqués.

Pendant la phase de précharge, le signal PREC est actif et la porte NAND délivre un signal de niveau bas. Les transistors de précharge sont alors conducteurs et le potentiel de précharge de la ligne de bit LB et de la ligne de référence LR commence à monter. Tant que ce potentiel de précharge est inférieur à 1 volt, les transistors T9 et T10 sont bloqués. De préférence, les moyens de précharge sont complétés par un transistor d'équilibrage T13 pour égaliser les potentiels de la ligne de bit et de la ligne de référence. Dans le schéma de la figure 1, ce transistor est commandé par le signal de commande des transistors de précharge. L'équilibrage est par conséquent exécuté pendant l'étape de précharge.

Dès que le potentiel de précharge des lignes LB et LR atteint 1 volt, les transistors T9 et T10 deviennent conducteurs et le transistor T10 impose sur une des entrées de la porte NAND un potentiel très bas proche du potentiel de masse. Pour que ce potentiel reste bas lorsque le transistor T11 est conducteur, le transistor T11 est de préférence choisi très résistif. La sortie de la porte NAND repasse à un niveau haut et la précharge des lignes LB et LR est alors interrompue.

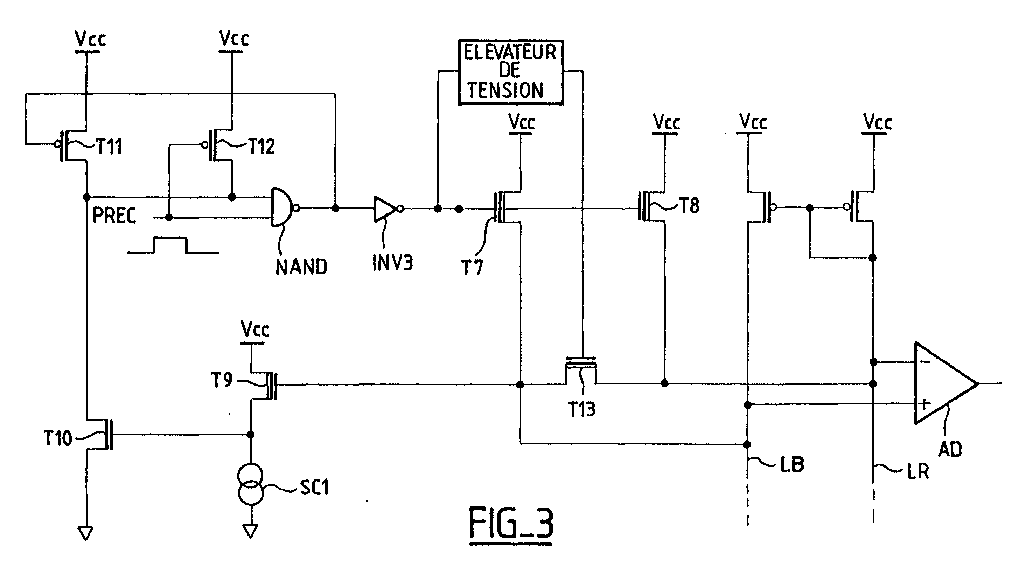

Dans le cas où le circuit de lecture est alimenté par une tension d'alimentation faible, par exemple 1,8 volts, les moyens de précharge sont complétés par un circuit élévateur de tension pour appliquer une tension suffisante sur la grille du transistor d'équilibrage. Cette variante est illustrée par la figure 3.

## Revendications

1. Circuit de lecture pour mémoire non volatile du type comportant une matrice de cellules mémoire (CM), le circuit de lecture étant relié d'une part auxdites cellules mémoires par l'intermédiaire d'au moins une ligne de bit (LB) et d'autre part à une cellule de référence (CR) par l'intermédiaire d'une ligne de référence (LR), lequel circuit de lecture comprend des moyens de précharge de la ligne de bit et de la ligne de référence,
caractérisé en ce que les moyens de précharge comportent des moyens pour interrompre la précharge de la ligne de bit et de la ligne de référence lorsque le potentiel de ces dernières atteint une valeur limite référencée par rapport à la masse.

2. Circuit de lecture selon la revendication 1, caractérisé en ce que les moyens de précharge comportent:
- un circuit de comparaison (T9, T10, SC1) du potentiel de précharge des lignes de bit et de référence avec ladite valeur limite, lequel circuit de comparaison délivre un signal de comparaison,
- des transistors de précharge (T7, T8) pour précharger les lignes de bit et de référence, et
- des moyens de commande (T11, T12, NAND, INV3) des transistors de précharge, lesquels moyens de commande reçoivent ledit signal de comparaison et un signal de précharge de période constante et fournissent un signal de commande aux transistors de précharge (T7, T8).

3. Circuit de lecture selon la revendication 2, caractérisé en ce que le circuit de comparaison comporte :
- un premier transistor (T9) de type N dont le drain est connecté à une borne d'alimentation (Vcc) du circuit de lecture, dont la grille est connectée à la ligne de bit (LB) et dont la source est connectée à une source de courant (SC1), et
- un second transistor (T10) de type N dont la grille est connectée à la source du premier transistor (T9), dont la source est connectée à la masse et dont le drain délivre ledit signal de comparaison.

4. Circuit de lecture selon la revendication 3, caractérisé en ce que le premier transistor (T9) est un transistor natif.

5. Circuit de lecture selon l'une des revendications 2 à 4, caractérisé en ce que les moyens de commande comportent:
- une porte (NAND) de type NON ET dont une première entrée est reliée au drain du second transistor (T10) et dont une seconde entrée reçoit ledit signal de précharge de période constante,
- un troisième transistor (T11) de type P dont la grille et le drain sont respectivement connectés à la sortie et à la première entrée de la porte NON ET (NAND), et dont la source est connectée à la borne d'alimentation (Vcc) du circuit,
- un quatrième transistor (T12) de type P dont le drain et la grille sont respectivement connectés aux première et seconde entrées de la porte NON ET (NAND), et dont la source est connectée à la borne d'alimentation (Vcc) du circuit; et
- une porte inverseuse (INV3) dont l'entrée est reliée à la sortie de la porte NON ET (NAND) et dont la sortie est connectée à la grille des transistors de précharge (T7, T8).

6. Circuit de lecture selon la revendication 5, caractérisé en ce que le troisième transistor (T11) est résistif.

7. Circuit de lecture selon l'une des revendications 2 à 6, caractérisé en ce que les moyens de précharge comportent en outre un transistor d'équilibrage (T13) pour équilibrer le potentiel des lignes de bit et de référence (LB, LR).

8. Circuit de lecture selon la revendication 7, caractérisé en ce que les moyens de précharge comportent également un moyen élévateur de tension pour produire une tension de commande du transistor d'équilibrage (T13).

## Patentansprüche

1. Leseschaltung für nichtflüchtigen Speicher mit einer Matrix von Speicherzellen (CM), wobei die Leseschaltung zum einen über mindestens eine Bitleitung (LB) mit den Speicherzellen und zum anderen über eine Referenzleitung (LR) mit einer Referenzzelle (CR) verbunden ist und wobei die Leseschaltung eine Vorrichtung zur Voraufladung der Bitleitung und der Referenzleitung aufweist,
dadurch gekennzeichnet,
dass die Voraufladungsvorrichtung Mittel aufweist, die die Voraufladung der Bitleitung und der Referenzleitung unterbrechen, wenn deren Potenzial einen Grenzwert erreicht, der in Bezug auf die Masse festgelegt ist.

2. Leseschaltung nach Anspruch 1, dadurch gekennzeichnet, dass die Voraufladungsvorrichtung aufweist:
- eine Schaltung (T9, T10, SC1) zum Vergleichen des Voraufladungspotenzials der Bitleitung und der Referenzleitung mit dem Grenzwert, wobei die Vergleichsschaltung ein Vergleichssignal liefert,
- Voraufladungstransistoren (T7, T8) zum Aufladen der Bitleitung und der Referenzleitung und
- Mittel (T11, T12, NAND, INV3) zur Steuerung der Voraufladungstransistoren, wobei die Steuerungsmittel das Vergleichssignal und ein Voraufladungssignal mit konstanter Periode aufnehmen und ein Steuerungssignal an die Voraufladungstransistoren (T7, T8) liefern.

3. Leseschaltung nach Anspruch 2, dadurch gekennzeichnet, dass die Vergleichsschaltung aufweist:
- einen ersten N-Transistor (T9), dessen Drain mit einer Anschlussklemme VCC der Leseschaltung, dessen Gate mit der Bitleitung (LB) und dessen Source mit einer Stromquelle (SC1) verbunden ist, und
- einen zweiten N-Transistor (T10), dessen Gate mit der Source des ersten Transistors (T9) und dessen Source mit der Masse verbunden ist und dessen Drain das Vergleichssignal liefert.

4. Leseschaltung nach Anspruch 3, dadurch gekennzeichnet, dass der erste Transistor (T9) ein ursprünglicher Transistor ist.

5. Leseschaltung nach einem der Ansprüche 2 bis 4, dadurch gekennzeichnet, dass die Steuerungsmittel aufweisen:
- ein NON-ET-Gatter (NAND), dessen erster Eingang mit dem Drain des zweiten Transistors (T10) verbunden ist und dessen zweiter Eingang das Voraufladungssignal mit konstanter Periode aufnimmt,
- einen dritten P-Transistor (T11), dessen Gate und Drain mit dem Ausgang beziehungsweise mit dem ersten Eingang des NON-ET-Gatters (NAND) und dessen Source mit der Anschlussklemme (VCC) der Schaltung verbunden sind,
- einen vierten P-Transistor (T12), dessen Drain und Gate mit dem ersten beziehungsweise mit dem zweiten Eingang des NON-ET-Gatters (NAND) und dessen Source mit der Anschlussklemme (VCC) der Schaltung verbunden sind, und
- ein invertierendes Gatter (INV3), dessen Eingang mit dem Ausgang des NON-ET-Gatters (NAND) und dessen Ausgang mit dem Gate der Voraufladungstransistoren (T7, T8) verbunden ist.

6. Leseschaltung nach Anspruch 5, dadurch gekennzeichnet, dass der dritte Transistor (T11) einen Widerstand besitzt.

7. Leseschaltung nach einem der Ansprüche 2 bis 6, dadurch gekennzeichnet, dass die Voraufladungsvorrichtung darüber hinaus einen Ausgleichstransistor (T13) zum Ausgleichen des Potenzials der Bitleitung (LB) und der Referenzleitung (LR) aufweist.

8. Leseschaltung nach Anspruch 7, dadurch gekennzeichnet, dass die Voraufladungsvorrichtung weiter eine spannungserhöhende Einrichtung aufweist, um eine Spannung zum Steuern des Ausgleichstransistors (T13) zu erzeugen.

## Claims

1. Read circuit for a non-volatile memory of the type having a matrix of memory cells (CM), the read circuit being connected on the one hand to the said memory cells by means of at least one bit line (LB) and on the other hand to a reference cell (CR) by means of a reference line (LR), the said read circuit comprising means of precharging the bit line and reference line,
characterised in that the precharging means include means for interrupting the precharging of the bit line and reference line when their potential reaches a limit value referenced with respect to earth.

2. Read circuit according to Claim 1, characterised in that the precharging means include:
- a circuit (T9, T10, SC1) for comparing the precharging potential of the bit and reference lines with the said limit value, the said comparison circuit delivering a comparison signal,
- precharging transistors (T7, T8) for precharging the bit and reference lines, and
- means (T11, T12, NAND, INV3) for controlling the precharging transistors, the said control means receiving the said comparison signal and a precharging signal with a constant period and supplying a control signal to the precharging transistors (T7, T8).

3. Read circuit according to Claim 2, characterised in that the comparison circuit includes:
- a first n-type transistor (T9) whose drain is connected to a supply terminal (Vcc) of the read circuit, whose gate is connected to the bit line (LB) and whose source is connected to a current source (SC1), and
- a second n-type transistor (T10) whose gate is connected to the source of the first transistor (T9), whose source is connected to earth and whose drain delivers the said comparison signal.

4. Read circuit according to Claim 3, characterised in that the first transistor (T9) is a native transistor.

5. Read circuit according to one of Claims 2 to 4, characterised in that the control means include:
- a gate (NAND) of the NAND type, a first input of which is connected to the drain of the second transistor (T10) and a second input of which receives the said precharging signal with a constant period,
- a third p-type transistor (T11) whose gate and drain are respectively connected to the output and first input of the NAND gate (NAND) and whose source is connected to the supply terminal (Vcc) of the circuit,
- a fourth p-type transistor (T12) whose drain and gate are respectively connected to the first and second inputs of the NAND gate (NAND), and whose source is connected to the supply terminal (Vcc) of the circuit; and
- an inverter gate (INV3) whose input is connected to the output of the NAND gate (NAND) and whose output is connected to the gate of the precharging transistors (T7, T8).

6. Read circuit according to Claim 5, characterised in that the third transistor (T11) is resistive.

7. Read circuit according to one of Claims 2 to 6, characterised in that the precharging means also include a balancing transistor (T13) for balancing the potential of the bit and reference lines (LB, LR).

8. Read circuit according to Claim 7, characterised in that the precharging means also include a voltage step-up means for producing a voltage controlling the balancing transistor (T13).
